Europäisches Patentamt

European Patent Office

Office européen des brevets

(11) Numéro de publication: **0 384 913**
**A1**

## (12) DEMANDE DE BREVET EUROPEEN

(21) Numéro de dépôt: **90870029.7**

(22) Date de dépôt: **21.02.90**

(51) Int. Cl.5: **F41G 3/26, H03K 5/15**

(30) Priorité: **21.02.89 BE 8900174**

(43) Date de publication de la demande:
**29.08.90 Bulletin 90/35**

(84) Etats contractants désignés:
**AT CH DE DK ES FR GB GR IT LI LU NL SE**

(71) Demandeur: **S.A. LEENTJENS-BOES**
**Rue En Bois 210**
**B-4400 Herstal(BE)**

(72) Inventeur: **Marganne, Henri**
**Rue En Bois 188**
**B-4400 Herstal(BE)**

(74) Mandataire: **Dellicour, Paul**
**Office de Brevets E. Dellicour rue Fabry**
**18/012**
**B-4000 Liège(BE)**

(54) **Circuit de pilotage à l'usage de systèmes de simulation et d'entraînement au tir.**

(57) Le circuit est caractérisé par une utilisation de compteurs basse consommation pour générer les impulsions et par une définition du code par CI logiques après générateur(s) avec possibilité d'émission simultanée de deux codes synchrones ou non synchrones.

FIG.1

A

B

C

D

E

## Circuit de pilotage à l'usage de systèmes de simulation et d'entraînement au tir

La présente invention concerne les systèmes de simulation et d'entraînement au tir et est relative au circuit de pilotage d'une ou plusieurs diodes laser pour générer une salve codée.

Actuellement, on utilise des circuits intégrés spécifiques ou dédiés aux émissions codées mais leur inconvénient consiste dans leur faible compatibilité aux modes de codage en présence d'impulsions.

C'est pourquoi il a paru avantageux suivant l'invention de créer un circuit de pilotage caractérisé par une utilisation de compteurs basse consommation pour générer les impulsions et par une définition du code par CI logiques après générateur(s) avec possibilité d'émission simultanée de deux codes synchrones ou non synchrones.

On connaît par le brevet US-A-4 781 593 la génération d'un code PPM de longueur déterminée 8 bits produit à partir de la lecture séquentielle du contenu d'une PROM.

La présente invention diffère de ce brevet, du fait que le circuit de pilotage de diode(s) laser à base de compteurs décimaux et de CI logiques basse consommation permet d'obtenir des codes, dont la longueur peut être adaptée aux besoins.

L'invention est décrite maintenant plus en détail sur la base des dessins annexés, à titre d'exemples uniquement, montrant en :

Figure 1 le schéma bloc d'un circuit de pilotage suivant l'invention;

Figure 2 une portion du schéma bloc de figure 1 à plus grande échelle concernant horloge et générateur de codes;

Figure 3 un diagramme de l'avance du compteur à chaque front montant de l'horloge;

Figure 4 une portion du schéma bloc de figure 1 à plus grande échelle concernant le choix des différents codes.

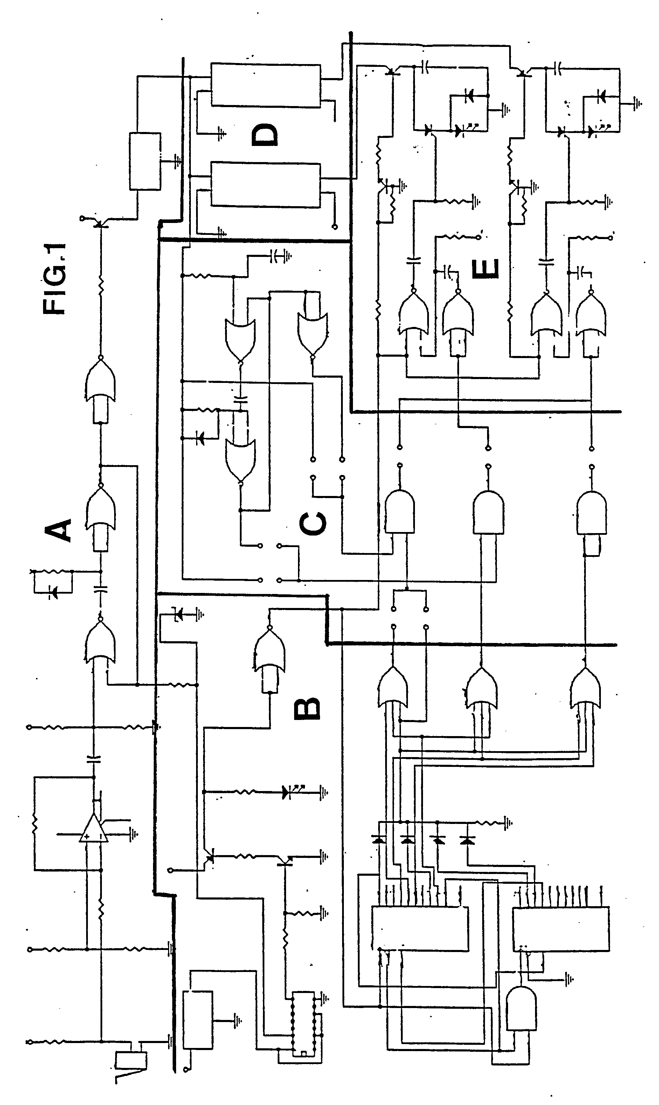

Dans le schéma bloc représenté en figure 1 le circuit de pilotage se divise en cinq parties :

A : circuit de détection et temporisateur de l'émission;

B : horloge et générateur de code;

C : choix des différents codes;

D : circuits élévateurs de tension;

E : driver diode laser.

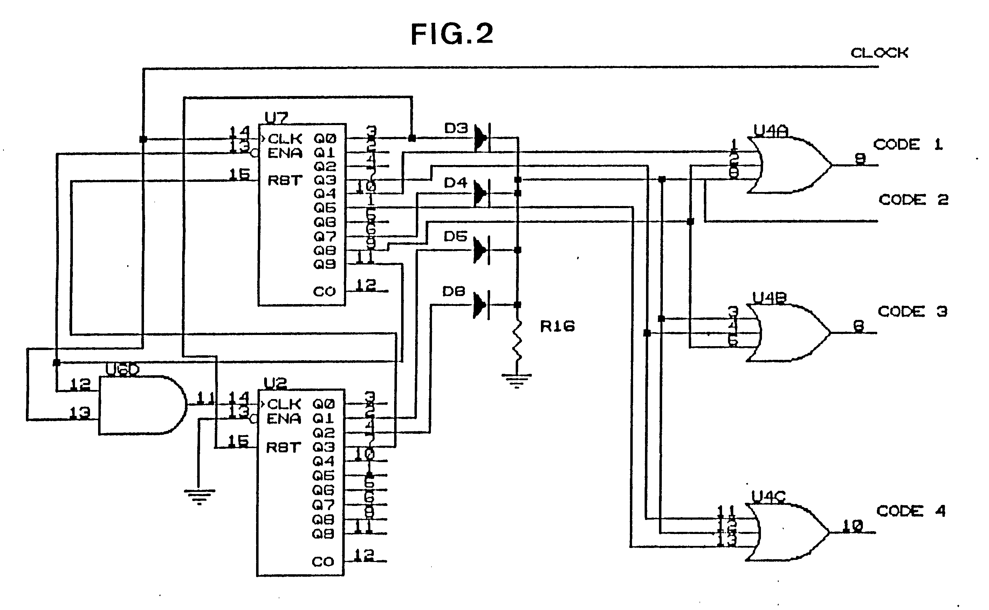

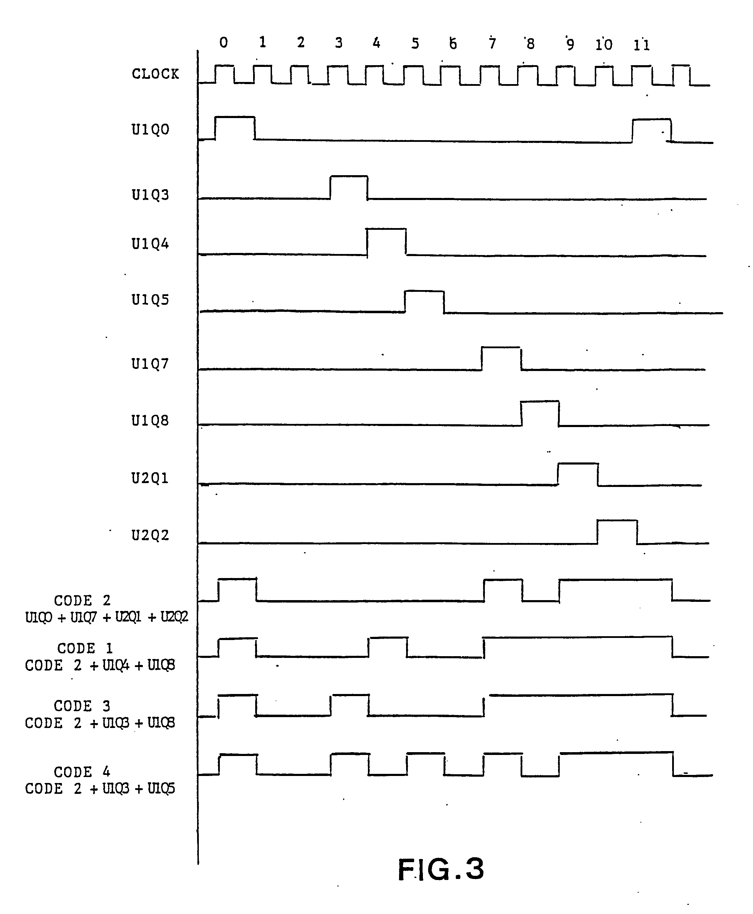

Le montage à base de compteurs décimaux et l'utilisation des diodes D3 et D6 et des portes "OU" U4A, U4B, U4C (portion de schéma bloc B - figure 2) permettent d'obtenir plusieurs codes simultanément. En effet, comme représenté en figure 3, à chaque front montant de l'horloge le compteur avance d'un pas.

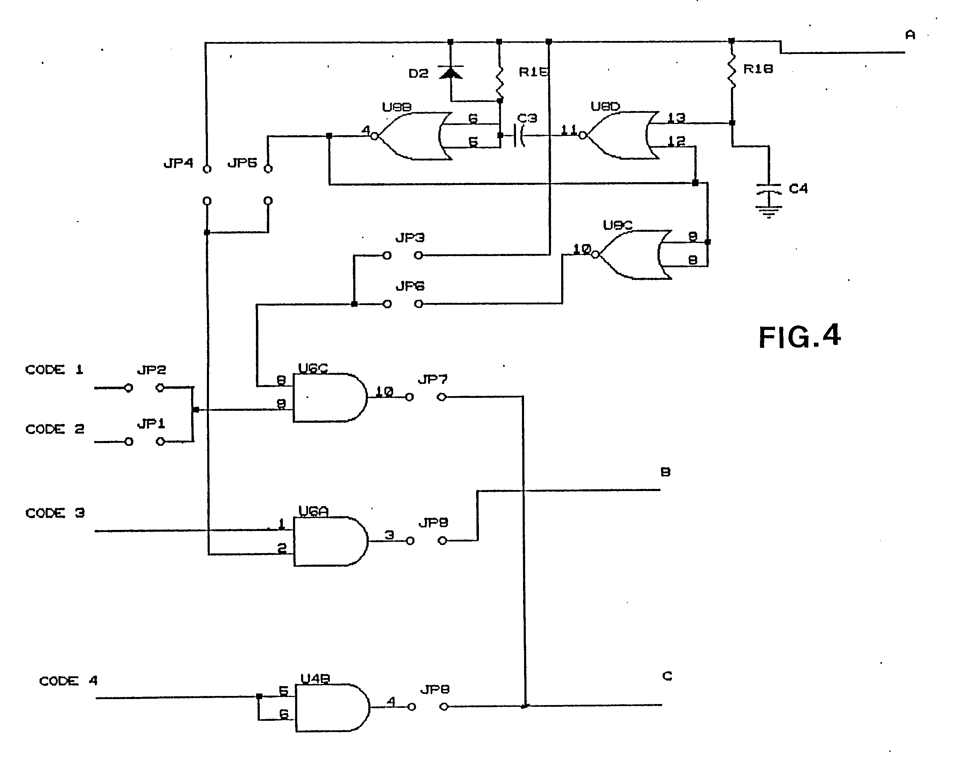

Le choix des différents codes s'explique par la portion de schéma bloc C (figure 4).

L'ensemble des portes U8B et U8D forment un monostable, la porte U8C un inverseur. Lors du déclenchement du système on obtient un front montant au point A, qui commande le monostable pendant un temps t. Les quatres codes sont disponibles aux points indiqués (code 1 code 4).

Suivant la position des jumpers JP3 à JP6 on peut obtenir des codes simultanés ou décalés dans le temps d'une durée "t" aux bornes 10-3-4 de U6.

Les jumpers JP1, JP2 et JP7 à JP9 permettent de sélectionner les différents codes.

## Revendications

Circuit de pilotage d'une ou plusieurs diodes laser pour générer une salve codée à l'usage de systèmes de simulation et d'entraînement au tir, caractérisé par une utilisation de compteurs basse consommation pour générer les impulsions et par une définition du code par CI logiques après générateur(s) avec possibilité d'émission simultanée de deux codes synchrones ou non synchrones.

FIG.1

FIG.2

FIG.3

FIG.4

EP 0 384 913 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | US-A-4 781 593  (BIRGE et al.)<br>* Figures 4,5; colonne 2, ligne 54 - colonne 3, ligne 62 *<br>--- | 1 | F 41 G    3/26<br>H 03 K    5/15 |
| A | FR-A-2 168 316  (HITACHI LTD)<br>* Figures 1,2,3; page 1, lignes 1-20; page 2, ligne 9 - page 4, ligne 2 *<br>--- | 1 | |
| A | US-A-3 585 371  (DOWLING)<br>* Figures 1,2; colonne 1, lignes 6-24; colonne 1, ligne 42 - colonne 3, ligne 7 *<br>----- | 1 | |

| | DOMAINES TECHNIQUES RECHERCHES (Int. Cl.5) |
|---|---|
| | F 41 G<br>H 03 K |

Le présent rapport a été établi pour toutes les revendications

| Lieu de la recherche | Date d'achèvement de la recherche | Examinateur |
|---|---|---|
| LA HAYE | 06-06-1990 | FEUER F.S. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P0402)